# EUROPEAN PATENT APPLICATION

(11) **EP 3 809 540 A1**
(43) Date of publication of application: **21.04.2021**
(21) Application number: 19315126.3
(22) Date of filing: 16.10.2019
(51) Int. Cl.: H01S 5/02, G02B 6/12, H01L 21/02, H01L 31/0352

(54) **DEVICE FOR REGROWTH OF A THICK STRUCTURE, PHOTONIC DEVICE COMPRISING THE SAME AND ASSOCIATED METHODS OF FABRICATION**

(71) Applicant: Nokia Solutions and Networks Oy, 02610 Espoo (FI); Commissariat à l'énergie atomique et aux énergies alternatives, 75015 Paris (FR); Thales, 92400 Courbevoie (FR)
(72) Inventor: Decobert, Jean, 91620 Nozay (FR); BesançON, Claire, 75014 Paris (FR); Fournel, Frank, 38190 Villard Bonnot (FR)
(74) Representative: Novagraaf Technologies

(57) **Abstract**

A device (1) for regrowth of a thick structure lattice-matched with InP comprising:
- a Si substrate (11),
- an interface layer of SiO₂ (12) on the Si substrate,
- a bonding layer (13) on the interface layer (12), said bonding layer (13) being made of a III-V material consisting of an alloy of the AlGaInAs family, and
- a regrowth layer (14) on the bonding layer (13), said regrowth layer (14) being made of InP.

## Description

### TECHNICAL FIELD

Various example embodiments relate to optical components, notably to photonic devices. More particularly, various embodiments relate to the fabrication of thick photonic devices fully regrown onto silicon.

### BACKGROUND

As known by those skilled in the art, silicon photonics lack efficient light emission and amplification. Thus, the integration of III-V semiconductors on top of silicon waveguide circuits is required to achieve complex integrated circuits. Heterogeneous integration through wafer bonding allows for dense and wafer-scale integration of the III-V optoelectronic components on the silicon photonic platform.

In this wafer bonding approach, there is only one epitaxial step of the full III-V heterostructure which is performed before the bonding step. This allows obtaining best quality III-V material. On the other hand, the epitaxial tool kit is much larger in the conventional III-V industry on adapted III-V wafers. Several and separate epitaxial steps can follow each other, such as selective area growth, butt-joint regrowth, cladding regrowth, lateral regrowth, most of them used for the so-called "*buried heterostructure lasers*". Nevertheless, additional processing and epitaxial steps are not possible before wafer bonding. The surface roughness must remain extremely low (RMS below 0.5 nm) to be compatible with bonding requisites. Moreover III/V devices would require a precise alignment at the bonding step in order for each device to be well placed on the top silicon circuits. This alignment might be extremely difficult, is time consuming and could be quite expensive

That is why other approaches have been developed by many industrial manufacturers in order to offer a larger epitaxial tool kit to designers of silicon photonic devices.

One of those is to add epitaxial regrowth steps after the bonding step. This implies to make possible the epitaxial regrowth on a III-V bonded seed onto a SiO₂/Si substrate. This so-called template must be compatible, in terms of coefficient of thermal expansion (CTE) and bonding interface mechanical resistance, with the very high temperature needed during epitaxy.

Regrowth on a directly bonded InP-SiO₂/Si membrane is a good way to avoid suffering from an InP/Si lattice mismatch and polarity differences as opposed to direct growth on silicon. However, a bonded membrane is exposed to the difference in thermal coefficient between III-V and Si. At a typical epitaxial growth temperature (610°C-650°C), this difference induces a thermal strain in the growing layer.

Up to now, the thermal strain effects have limited the total regrown thickness achievable while keeping the high level of material quality required for photonic devices. The regrowth of a thick structures (typically from 0.7 µm up to 3 µm) have been investigated. Typically, it has been shown that the photoluminescence signal intensity decreases as the regrown layer thickness increases. Furthermore, the surface roughness RMS (Root Mean Square) of these structures are in the range of 10 nm, more than ten time higher than on the same structure regrown on an InP substrate. This higher roughness accounts for the lower material quality. By surface roughness RMS, it is meant in the frame of the present application is the Root Mean Square surface roughness average of the profile height deviations from the mean line, recorded within the evaluation length.

Until now, the total thickness of the grown material, whether it is Multiple Quantum Well (MQW) active layers or lateral confinement layers, is limited to typically a half micron. This thickness limitation directly impacts the achievable laser designs and has largely encouraged the *"membrane buried heterostructure laser*" technique where a thin MQW stack is laterally buried in order to form a p-i-n lateral junction instead of a thick vertical p-i-n junction.

Despite the demonstration of high material quality and component performances, this thickness limitation directly impacts the achievable laser designs used in the conventional InP platform know-how, based on a thick vertical p-i-n junction. It is needed to overcome these difficulties of the effects of thermally induced stress and the small total thickness of III-V material.

### SUMMARY

Example embodiments of the invention aims to remedy all or some of the disadvantages of the above identified prior art.

The embodiments and features, if any, described in this specification that do not fall under the scope of the independent claims are to be interpreted as examples useful for understanding various embodiments of the invention.

A first example embodiment relates then to a device for regrowth of a thick structure lattice-matched with InP comprising:
- a Si substrate,
- an interface layer of SiO₂ on the Si substrate,
- a bonding layer on the interface layer, said bonding layer being made of a III-V material consisting of an alloy of the AlGaInAs material family.
- a regrowth layer on the bonding layer, said regrowth layer being made of InP.

By alloy of the AlGaInAs material family, it is meant, in the present application, components comprising As and at least two elements chosen among of the group consisting of Al, Ga, and In.

The device for regrowth according to the first example embodiment offers a way to put up with the effects of thermally induced stress and to allows the regrowth of a thick structure of III-V material lattice-matched with InP, by using a specific III-V material at the bonding interface with SiO₂/Si, which offers a higher bonding strength. This enables to further increase the total thickness of III-V material.

Advantageously, the interface layer of SiO₂ may comprise a silicon waveguide.

Advantageously, the bonding layer AlGaInAs composition/material family is chosen to obtain an almost perfect lattice match with InP lattice parameter (with a tolerance usually better than 0.1% and typically around 0.01% or 100 PPM).

Advantageously, we can use an alloy (Al_{z}Ga_{1-z})ₓIn₁₋ₓAs with 0 ≤ z ≤ 1 and 0.465 ≤ x ≤ 0.481, lattice matched to InP.

Advantageously, the bonding layer may consist of GaInAs which has the advantage to form a stable interface with a thermal SiO₂. Prefarably, we can use an alloy GaₓIn₁₋ₓAs with 0.465 ≤ x ≤ 0.481 lattice matched to InP.

Advantageously, the bonding layer may consist of AlInAs which has the advantage that the material formed at the interface resulting from the reaction between AlInAs and thermal SiO₂ has a very high stability. Advantageously, we can use an alloy AlₓIn₁₋ₓAs with 0.465 ≤ x ≤ 0.481 lattice matched to InP.

In particular, a device comprising a bonding layer on the interface layer consisting in an InP/AlInAs (10nm)-bonded-to-SiO₂/Si(substrate) stack offers a strong adherence which permits the bonding structure to resist an important strain energy due to the thermal coefficient expansion (CTE) mismatch and a thick regrowth. The thicker the structure in regrowth, the higher chance of an evolution of the bonding interface due to the thermal strain energy. This InP/AlInAs(10nm)-bonded-to-SiO₂/Si(sub) may serve for all kind of support for regrowth of a thick structure lattice-matched with InP. More particularly, for telecom-oriented applications, a 3µm-thick vertical p-i-n junction, both for emission or reception, may be regrown, including cladding, active, contact layers.

Advantageously, the thickness of the bonding layer may be comprised between 1 and 100 nm, preferably between 5 and 50 nm, and even more preferably between 8 and 12 nm.

Advantageously, the thickness of the regrowth layer being made of InP may be of about 100 nm.

A second example embodiment relates to a photonic device for combining a silicon "*Si*" material and a III-V material comprising:
- the device for regrowth of a thick structure lattice-matched with InP according to the first example embodiment,
- an inferior cladding on the regrowth layer of the device for regrowth according to the first example embodiment, said inferior cladding comprising at least one III-V material layer,
- at least an active layer on the inferior cladding,
- a superior cladding on the active layer, said superior cladding comprising at least one III-V material layer.

The first and second III-V materials may be same or different.

Advantageously, the active layer may be a Multiple Quantum Well layer. In that case, the photonic device may be used as a light tuning device, such as optical waveguide, laser, modulator or optical amplifier.

Advantageously, the active layer may be a thick absorption layer. In that case, the photonic device may be used as a light detector device.

Advantageously the surface roughness RMS of the superior cladding may be less than 1 nanometer.

Advantageously the total thickness of the inferior cladding, the active layer, and the superior cladding may be higher than 1 µm, and preferably of about 3 µm.

Advantageously, the total thickness of the first III-V material layer, the active layer, the second III-V material layer and the third III-V material layer is higher than 1 micron, and preferably about 3 microns.

A third example embodiment relates to a method of fabrication of a device for regrowth of a thick structure lattice-matched with InP comprising the following steps:
- providing a Si substrate;
- layering the Si substrate with an SiO₂ interface layer by thermal oxidation of said Si substrate;
- providing an InP substrate;
- layering a regrowth layer made of InP on the InP substrate;
- layering a bonding layer made of an alloy of the (AlGa)InAs family on the regrowth layer, by epitaxial growth so as to form a stack;
- bonding the SiO₂ interface layer and the bonding layer of the stack;
- removing the InP substrate.

Advantageously, the step of bonding the SiO₂ interface layer and the bonding layer of the stack may be realized by hydrophilic direct bonding.

Advantageously, the method of fabrication of a device for regrowth of a thick structure lattice-matched according to the third example embodiment may further comprise the following steps:
- between the steps of providing an InP substrate and the step of layering a regrowth layer made of InP, a step of layering a stop-etch layer on the InP substrate; and
- a step of removing the stop-etch layer that is realized simultaneously with removal of the InP substrate.

In that case, the step of removing the stop-etch layer and the InP substrate may be preferably realized by chemical selective etching.

Advantageously, the substrate might be partially removed using a grinding step to minimize the amount of InP substrate material removed by chemical selective etching.

A fourth example embodiment relates to a method for growing a semiconductor heterogeneous structure on a Si substrate comprising the following steps:
- providing a device for regrowth of a thick structure lattice-matched with InP according to the first embodiment, or fabricated according to the method of fabrication of the fourth embodiment; growing at least a first III-V material layer on the regrowth layer of said device for regrowth, so as to form an inferior cladding,
- growing an active layer on the inferior cladding,
- growing at least a second III-V material layer on the active layer, so as to form a superior cladding;
- growing a third III-V material layer on the superior cladding.

Advantageously, the step of growing the inferior cladding on the regrowth layer, the step of growing the active layer on the inferior cladding, and the step of growing the superior cladding on the active layer may be realized by Metalorganic Vapor Phase Epitaxy (MOVPE or equivalently organometallic vapor-phase epitaxy OMVPE) growth or by Molecular Beam Epitaxy growth.

Advantageously, the method for growing a semiconductor heterogeneous structure on a Si substrate according to the fourth example embodiment may comprise the following features:
- the inferior cladding layer is made of InP,
- the active layer is a Multiple Quantum Well layer,
- the superior cladding is made of InP,
- the second III-V material layer on top of the superior cladding is made of GaInAs.

### BRIEF DESCRIPTION OF THE DRAWINGS

Some example embodiments are now described, by way of example only, and with reference to the accompanying drawings in which:
- FIG. 1 schematically represents a device for regrowth of a thick structure lattice-matched with InP according to some example embodiments;
- FIG. 2A to 2C schematically depict the different steps of a method of fabrication of a device for regrowth of a thick structure lattice-matched with InP according to some example embodiments;
- FIG. 3 are microscopic images after annealing under the standard growth conditions on a) a device for regrowth (InP bonding), b) a device for regrowth of a thick structure according to some example embodiments with an AlInAs bonding, and c) a device for regrowth of a thick structure according to some example embodiments with an GaInAs bonding;
- FIG. 4A and FIG. 4B schematically represent a photonic device for, respectively on SiO₂/Si and on SiO₂/Si waveguide/Si, for combining a silicon "*Si*" material and a III-V material according to some example embodiments;
- FIG. 5 are Scanning Electron transmission Microscopic (STEM) and Atomic Force Microscopic (AFM) images of a photonic device according to some example embodiments, with a vertical structure grown onto a bonded seed for a total thickness of about 3 µm;
- Figure 6a schematically represents a photonic device according to some example embodiment presenting a 2750 nm thick regrown structure and Figure 6B is a graph showing the evolution as a function of wavelength of a photoluminescence (PL) signal on the thick regrown structure of the photonic device shown on figure 6A ;
- Figure 7A schematically represents a laser according to the third mode of realization (with a wavelength of 400 µm), and Figure 7B is a graph showing the evolution of the power as a function of current intensity, for the laser shown on Figure 7A.

The same reference number represents the same element or the same type of element on all drawings, unless stated otherwise.

### DETAILLED DESCRIPTION

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention, and are to be construed as being without limitation to such specifically recited examples and conditions. As a result, the invention is not limited to the specific embodiments or examples described below, but by the claims and their equivalents.

In the following description, well-known functions or constructions by the man skilled in the art are not described in detail since they would obscure the invention in unnecessary detail.

In the following description of the figures, schematic representations are non-limiting and serve only for the understanding of the invention.

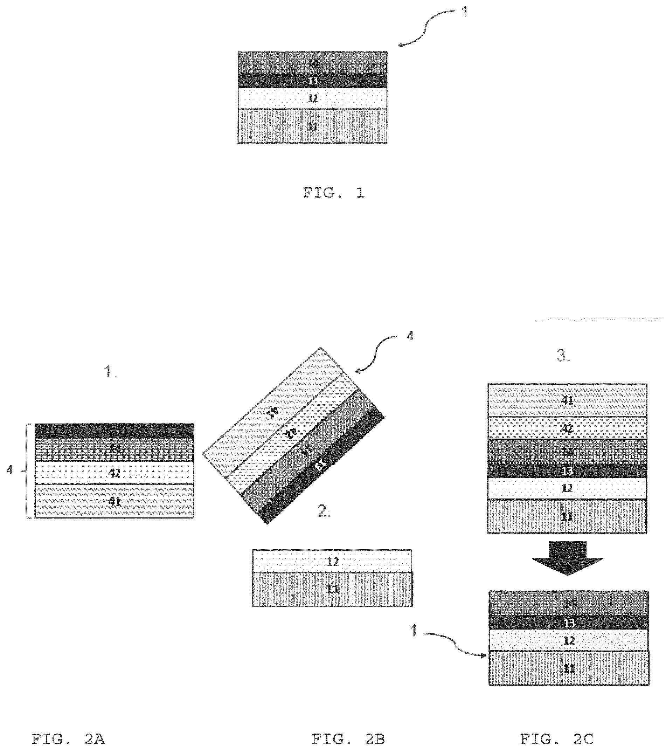

Figure 1 schematizes a device for regrowth 1 of a thick structure lattice-matched with InP according to some example embodiments. comprising:
- a silicon (Si) substrate 11,
- an interface layer of silicon dioxide (SiO₂) 12 on the Si substrate 11,
- a bonding layer 13 made of III-V compound Aluminum Indium Arsenide (AlInAs) or III-V compound Indium Gallium Arsenide (GaInAs) on the interface layer 12, and
- a regrowth layer 14 made of Indium Phosphide (InP) on the bonding layer 13.

The device for regrowth 1 shown on figure 1 is obtained by a method of fabrication according to the third example embodiment, the different steps of which are schematically depicted by Figures 2A to 2C.

In particular, Figure 2A depicts the first group of steps of this method of fabrication comprising:
- providing an InP substrate 41;
- preferably, but not necessarily, layering a stop-etch layer 42 on the InP substrate 41;
- layering a regrowth layer 14 made of InP on the InP substrate 41 or, where applicable on the stop-etch layer 42;
- layering a bonding layer 13 made of AlInAs or GaInAs on the regrowth layer 14, by epitaxial growth in an example, so as to form a stack 4.

Advantageously the bonding is realized by hydrophilic direct bonding.

Figure 2B depicts the second group of steps of the method of fabrication according to the third example embodiment, comprising:
- providing a Si substrate 11;
- layering the Si substrate with an SiO₂ interface layer 12 by thermal oxidation of said Si substrate 11, preferably at a temperature between 800°C and 1250°C (notably at 950 or 1050°C on silicon with a dry oxygen or wet atmosphere);
- bonding the SiO₂ interface layer 12 and the bonding layer 13 of the stack 4 (more preciously the bonding layer 13) .

Advantageously the bonding is realized by hydrophilic direct bonding.

Figure 2C depicts the last step of the method of fabrication according to the third example embodiment, corresponding to the removal of the InP substrate 41. The removal of the InP substrate 41 may be realized either by selective chemical etching or by ion implantation followed by splitting and polishing. In the case of a removal selective chemical etching, it is preferable to layer a stop-etch layer 42 on the InP substrate 41, before layering the regrowth layer 14. In that case, a step of removing the stop-etch layer 42 would be realized simultaneously with the removal of the InP substrate 41.

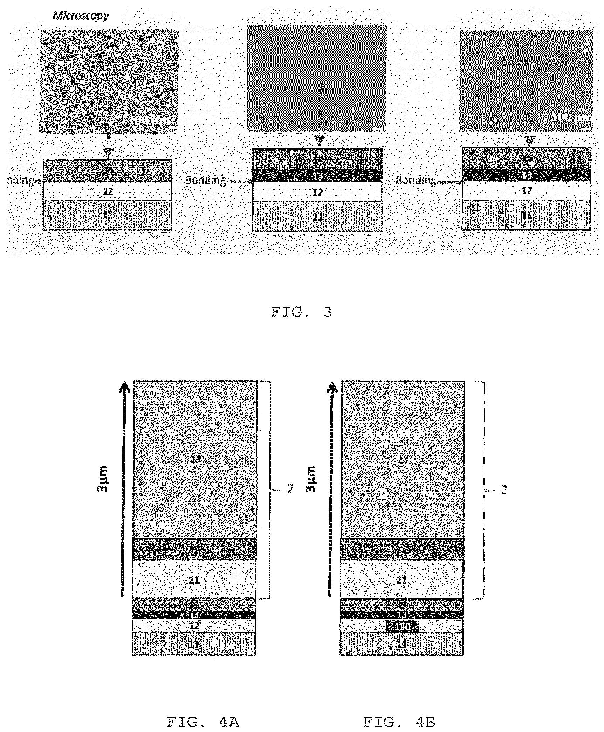

FIG. 3 are microscopic images (100 µm scale) after annealing under the standard growth conditions on a) a device for regrowth with InP bonding, b) a device for regrowth of a thick structure according to some example embodiments with an AlInAs bonding 13, and c) a device for regrowth of a thick structure according to some example embodiments with an GaInAs bonding 13. In particular, in the case of an InP layer 14 as bonding layer (i.e. no bonding layer 13 as depicted by FIG. 3a showing a device for regrowth, voids or cavities are noticed at the bonding interface (FIG. 3a) whereas, thanks to exemplary embodiments, in the case of an intermediate AlInAs bonding layer 13 (FIG. 3b) or an GaInAs bonding layer 13 (FIG 3c) formed between the interface SiO₂ layer 12 and the InP regrowth layer 14, a thermally stable material is formed at the interface from the reaction between AlInAs (respectively GaInAs) and the thermal SiO₂.

Since both GaInAs and AlInAs bonding layers 13 at the bonding interface show thermal stability during annealing, an epitaxial regrowth of thick structure (of about 1 to 3 µm) is achievable, as schematically depicted by Figure 4. This thick structure 2 comprises, successively from the device for regrowth 1 according to some example embodiments (as depicted by FIG. 1):
- an inferior cladding 21, comprising at least a first III-V material layer,
- at least an active layer 22 on the inferior cladding 21, and
- on the active layer 22, a superior cladding 23 comprising at least a second III-V material layer.

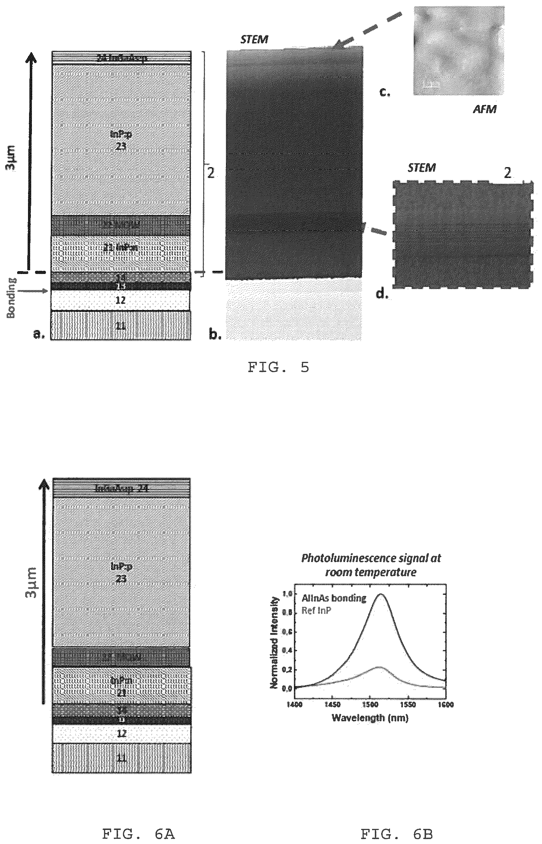

This thick structure 2 on the device for regrowth 1 according to the first embodiment constitutes a photonic device 3 according to the some example embodiments, that may include or not a silicon waveguide 120 that is embedded in the interface layer of SiO₂ 12 on the Si substrate 11. This photonic device 3 may be typically used for emission or detection applications needed into the silicon photonic platform, fully regrown onto silicon. The III-V material family materials of the inferior cladding 21 and superior cladding 23 match the InP lattice parameters and is fully regrown onto a specific InP-AlGaInAs thin structure previously bonded onto SiO₂/Si (device for regrowth 1). Best results in terms of seed material quality can be obtained with a 10 nm thick AlInAs layer followed by an InP buffer layer onto a thermal silica formed on silicon. A use case is a laser structure 3 which includes a MQW active core 22 surrounded by n type 21 and p type 23 thick claddings for a total thickness of substantially 3 µm (Figures 5 to 7). Advantageously, the combination of AlGaInAs bonding layer with III-V material and Silicon offers an enhanced durability considering strain stress due to thermal effects, which allows to obtain an increased thickness of the resulting assembly.

Material-related characterizations have been done on the structure 2 grown onto an AlInAs bonding layer 13.

Thus FIG. 5b, 5c, 5d are respectively Scanning Electron transmission Microscopic (STEM) and Atomic Force Microscopic (AFM) images of a photonic device 3 according to the third example embodiment, with a vertical structure 2 grown onto an AlInAs bonding layer 13, for a total thickness of about 3 µm. Advantageously, the STEM analysis does not show any trace of dislocations and the mean roughness is less than 1nm (FIG 5c).

Figure FIG. 6a and 6b show the evolution as a function of wavelength of a photoluminescence (PL) signal on a 2750 nm thick regrown structure of a photonic device according some exemplary embodiments (FIG. 6b), shown next to the schematically adjacent representation of said photonic device (FIG. 6a). Figure FIG. 6b clearly shows that the intensity of the photoluminescence (PL) signal is higher if the thick structure 2 has grown on an AlInAs bonding layer 13 than on an InP layer, for each wavelength tested.

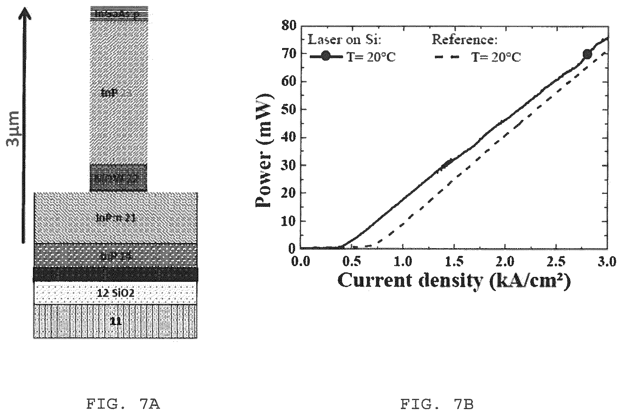

Figure FIG. 7b shows the evolution of the power as a function of current intensity, for a laser device according to some exemplary embodiments, shown next to the schematically adjacent representation of said laser device (FIG. 7a). This figure shows that not only high-material quality has been demonstrated but also a laser effect has been performed based on the same vertical laser-structure with a substantially increased thickness.

## Claims

1. A device for regrowth (1) of a thick structure lattice-matched with InP comprising:
- a Si substrate (11),
- an interface layer of SiO₂ (12) on the Si substrate (11),
- a bonding layer (13) on the interface layer (12), said bonding layer (13) being made of a III-V material consisting of an alloy of the AlGaInAs family, and
- a regrowth layer (14) on the bonding layer, said regrowth layer being made of InP.

2. A device (1) according to claim 1, where the interface layer (12) of SiO₂ comprises a silicone waveguide (120).

3. A device according to claims 1 or 2, where the bonding layer (13) is made of AlInAs.

4. A device according to anyone of claims 1 to 3, where the thickness of the bonding layer (13) is comprised between substantially 1 and substantially 100 nm, and preferably between substantially 5 and substantially 50 nm.

5. A photonic device (3) for combining a silicon "Si" material and a III-V material comprising:
- a device for regrowth (1) of a thick structure (2) lattice-matched with InP according to any of the claims 1 to 4,
- an inferior cladding (21) on the regrowth layer (14) of said device for regrowth (1), said inferior cladding (21) comprising at least a first III-V material layer,
- at least an active layer (22) on the inferior cladding (21),
- a superior cladding (23) on the active layer (22), said superior cladding (23) comprising at least a second III-V material layer.

6. A photonic device (3) according to claim 5, wherein the active layer (22) is a Multiple Quantum Well layer.

7. A photonic device (3) according to claim 5, wherein the active layer (22) is a thick absorbent layer.

8. A photonic device (3) according to claim 7, where the surface roughness of the superior cladding (23) is less than 1 nanometer.

9. A photonic device (3) according to claim 7 or 8, where the total thickness of the inferior cladding (21), the active layer (22), and the superior cladding (23) is higher than 1 µm, and preferably about 3 µm.

10. A method of fabrication of a device (1) for regrowth of a thick structure (2) lattice-matched with InP comprising the following steps:
• providing a Si substrate (11);
• layering the Si substrate with an SiO₂ interface layer (12) by thermal oxidation of said Si substrate (11);
• providing an InP substrate (41);
• layering a regrowth layer (14) made of InP on the InP substrate (41);
• layering a bonding layer (13) made of an alloy of the AlGaInAs family on the regrowth layer (14), by epitaxial growth so as to form a stack (4);
• bonding the SiO₂ interface layer (12) and the bonding layer (13) of the stack (4);
• removing the InP substrate (41).

11. A method of fabrication according to claims 10, wherein the step of bonding the SiO₂ interface layer (12) and the bonding layer (13) of the stack (4) is realized by hydrophilic molecular bonding.

12. A method of fabrication according to claims 10 or 11, further comprising the following steps:
• between the steps of providing an InP substrate (41) and the step of layering a regrowth layer made of InP (14), a step of layering a stop-etch layer (42) on the InP substrate (41); and
• a step of removing the stop-etch layer (42) that is realized substantially simultaneously with the step of removing of the InP substrate (41).

13. A method of fabrication according to claim 12, where the step of removing the stop-etch layer (42) and the InP substrate (41) is realized by chemical selective etching.

14. A method for growing a semiconductor heterogeneous structure on a Si substrate (11) comprising the following steps:
• providing a device for regrowth (1) of a thick structure (2) lattice-matched with InP as defined in any of the claims 1 to 4, or fabricated according to the method of fabrication according to any of the claims 10 to 13,
• growing at least a first III-V material layer on the regrowth layer (14) of said device for regrowth (1), so as to form an inferior cladding (21),
• growing an active layer (22) on the inferior cladding (21),
• growing at least a second III-V material layer on the active layer (22), so as to form a superior cladding (23),
• growing a third III-V material layer (24) on the superior cladding (23).

15. A method for growing a semiconductor heterogeneous structure on a "Si" substrate according to claim 14, wherein:
• the inferior cladding layer (21) is made of InP,
• the active layer (22) is a Multiple Quantum Well layer,
• the superior cladding (23) is made of InP.
• the second III-V material layer (24) on top of the superior cladding (23) is made of GaInAs.
